Europäisches Patentamt

European Patent Office

Office européen des brevets

(19)

(11) Veröffentlichungsnummer : **0 081 598**
**B1**

(12) **EUROPÄISCHE PATENTSCHRIFT**

(45) Veröffentlichungstag der Patentschrift :
24.04.85

(51) Int. Cl.⁴ : **H 03 L   7/18**

(21) Anmeldenummer : 81110300.1

(22) Anmeldetag : 10.12.81

(54) Digitale Phasen/Frequenzregelschaltung.

(43) Veröffentlichungstag der Anmeldung :
22.06.83 Patentblatt 83/25

(45) Bekanntmachung des Hinweises auf die Patenterteilung : 24.04.85 Patentblatt 85/17

(84) Benannte Vertragsstaaten :
DE FR GB IT NL

(56) Entgegenhaltungen :
EP-A- 0 012 899
DE-A- 2 932 049
GB-A- 1 481 786
US-A- 3 988 696
US-A- 4 149 125

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Lindstedt, Günther
Dietenbachstrasse 11a
D-7800 Freiburg/Br. (DE)
Erfinder : Nopper, Guido Hugo, Ing. grad.
Schauinslandstrasse 8
D-7801 Umkirch (DE)

(74) Vertreter : Stutzer, Gerhard, Dr.
Deutsche ITT Industries GmbH Patent- und Lizenzabteilung Hans-Bunte-Strasse 19 Postfach 840
D-7800 Freiburg (DE)

## Beschreibung

Die Erfindung betrifft eine digitale Phasen/Frequenzregelschaltung, bei der das Signal eines von einem Phasendiskriminator bezüglich der Frequenz spannungsgesteuerten Oszillators mit einer Kapazitätsdiode über einen seiner Frequenzwahl dienenden einstellbaren Frequenzteiler am ersten Eingang des Phasendiskriminators und das Signal eines Referenzsoszillators über einen Referenzfrequenzteiler dem zweiten Eingang des Phasendiskriminators zugeführt sind und bei der der Phasendiskriminator einen ersten Ausgang für Impulse zur Frequenzanhebung und einen zweiten Ausgang für Impulse zur Frequenzabsenkung des Oszillators aufweist. Eine derartige Phasen/Frequenzregelschaltung ist beispielsweise aus der Offenlegungsschrift DE-A-28 56 211 (= EP-A-12 899) bekannt.

Derartige Phasen/Frequenzregelschaltungen werden vorzugsweise in Rundfunk- und Fernsehgeräten zur Senderwahl eingesetzt und auch als PLL-Systeme oder Frequenz-Synthese-Systeme bezeichnet. Beim Einsatz in Rundfunk- und Fernsehgeräten ist der spannungsgesteuerte Oszillator meistens mit mindestens einer Kapazitätsdiode ausgerüstet, der die Regelspannung zur Kapazitätsänderung und somit zur Frequenzänderung zugeführt ist, wobei der spannungsgesteuerte Oszillator bei nach dem Superhet-Prinzip arbeitenden Tunern der Zwischenfrequenz-Oszillator ist.

Derartige Anordnungen sind meistens noch mit einer Suchlaufeinrichtung versehen, mittels der das eingestellte Frequenzband selbsttätig durchlaufen wird, bis ein empfangswürdiger Sender gefunden ist. Insbesondere bei derartigen Suchläufen, aber auch bei vom Benutzer vorgenommenen Umschaltungen zwischen weit auseinanderliegenden Kanälen eines Frequenzbandes ist es möglich, daß die Regelspannung bis in den Bereich der Sperrdurchbruchspannung der Kapazitätsdioden gelangt, in welchem Bereich sie, die vorher einen hochohmigen Serienwiderstand aufwiesen, nunmehr schnell niederohmig werden und den Oszillator somit stark bedämpfen, so daß seine Schwingungen aussetzen können. Andererseits ist es aber auch möglich, daß die Regelspannung so klein wird, daß die Kapazitätsdioden bis in den Flußbereich gesteuert werden. Auch dann tritt eine starke Bedämpfung des Oszillators ein.

In beiden Fällen kann die Phasen/Frequenzregelschaltung aus dem jeweils unerwünschten Betriebszustand nicht von selbst herausfinden. Hier setzt die Erfindung, wie sie in den Patentansprüchen angegeben ist, ein, und es liegt ihr die Aufgabe zugrunde, mittels schaltungstechnischer Maßnahmen sicherzustellen, daß die beiden geschilderten Betriebszustände, wenn sie auftreten, überwunden werden können.

In der Figur der Zeichnung ist blockschaltbildmäßig ein Ausführungsbeispiel der Erfindung zur näheren Erläuterung dargestellt. Die eigentliche Phasen/Frequenzregelschaltung umfaßt den Referenzoszillator RO, der üblicherweise wegen der erforderlichen Frequenzkonstanz ein Quarzoszillator sein wird, ferner den Referenzfrequenzteiler RT, dem das Ausgangssignal des Referenzoszillators RO zugeführt ist und an dessen Ausgang ein entsprechend der fest vorgegebenen Teilungszahl frequenzgeteiltes Signal auftritt. Ein bestimmter Bereich aufeinanderfolgender Zustände des Referenzfrequenzteilers ist mittels des Decoders D überwacht, d. h. an seinem Ausgang tritt bei vorausgesetzter positiver Logik der positivere H-Pegel der beiden Binärsignalpegel H, L auf, wenn er in einen dieser überwachten Zustände gelangt. Ferner ist der bezüglich seiner Frequenz spannungsgesteuerte Oszillator VO vorgesehen, der mindestens eine Kapazitätsdiode enthält, an die über den Steuereingang Ev die Regelspannung angelegt ist, und dessen Ausgangssignal dem Eingang des einstellbaren Frequenzteilers ET zugeführt ist. Die Teilungszahl dieses Frequenzteilers kann durch ein entsprechendes Einstellsignal, das an seinen Einstelleingang Es anzulegen ist, bestimmt werden.

Das Ausgangssignal des Referenzfrequenzteilers RT ist dem ersten Eingang E1 und das des einstellbaren Frequenzteilers ET dem zweiten Eingang E2 des Phasendiskriminators P zugeführt. Dieser gibt an seinem ersten Ausgang A1 Impulse zur Frequenzanhebung und an seinem zweiten Ausgang A2 Impulse zur Frequenzabsenkung des Oszillators VO ab. Im eingerasteten Zustand geben die beiden Ausgänge A1, A2 pro Zeiteinheit dieselbe Anzahl von Impulsen ab. Diese steuern die beiden Konstantstromquellen Q1, S2 so, daß am Ausgang des Glättungsglieds G einen konstante, die Frequenz des Oszillators VO bestimmende Gleichspannung auftritt, die sich bei Änderung des am einstellbaren Frequenzteilers ET liegenden Einstellsignals dadurch verändert, daß der entsprechende Ausgang mehr Impulse pro Zeiteinheit abgibt als der andere.

Zur Lösung der Aufgabe sind nun einerseits Schaltungsteile vorgesehen, die erst aktiv werden, wenn nach einer wählbaren Wartezeit festgestellt ist, daß die Phasen/Frequenzregelschaltung nicht mehr in ihrem eingerasteten Betrieb arbeitet. Hierzu dienen der bereits erwähnte Decoder D, das erste UND-Gatter U1, das rücksetzbare erste digitale Monoflop M1 und das zweite digitale Monoflop M2 sowie der Inverter I. Andererseits sind Schaltungsteile vorgesehen, die eine Information darüber speichern, welcher der beiden Ausgänge A1, A2 des Phasendiskriminators B zuletzt überwiegend aktiv war, d. h. eine Information darüber, ob die Abstimmspannung gerade in der Nähe der Sperrdurchbruchspannung oder der Flußspannung der Kapazitätsdiode liegt. Dieser Schaltungsteil ist das SR-Flipflop RS mit dem zweiten und dem dritten UND-GATTER U2, U3 und der ersten sowie der zweiten Signalweiche S1, S2.

Mittels des ersten UND-Gatters U1 sind das Ausgangssignal des einstellbaren Frequenzteilers ET und das Ausgangssignal des Decoders D UND-verknüpft, d. h. der Decoderausgang und der Frequenzteilerausgang sind mit je einem Eingang dieses UND-Gatters verbunden. Sein Ausgang liegt am Reset-Eingang Er des rücksetzbaren ersten Monoflop M1. An seinem Ausgang tritt somit nur dann ein Ausgangsimpuls auf, wenn während seine metastabilen Zustandes kein Rücksetz-Signal vom ersten UND-Gatter U1 abgegeben wird. Im eingerasteten Zustand der Phasen/Frequenzregelhaltung ist das auch nicht der Fall, denn dann liegen sämtliche Ausgangsimpulse des einstellbaren Frequenzteilers ET innerhalb des vom Decoder D gebildeten Zeitfensters und es tritt am Reset-Eingang Er des ersten Monoflops M1 immer ein Rücksetzimpuls auf, bevor das Ende des metastabilen Zustandes erreicht ist. Wenn jedoch andererseits einer der unerwünschten Betriebszustände auftritt, aus der die Schaltung von selbst nicht herausfinden kann, so liegen keine in das vom Decoder D gebildete Zeitfenster fallenden Impulse des einstellbaren Frequenzteilers ET mehr vor, so daß am Ausgang des ersten Monoflops M1 ein Impuls auftritt. Dieser ist dem Triggereingang Et des zweiten Monoflops M2 zugeführt, so daß es an seinem Ausgang einen entsprechend der Dauer seines metastabilen Zustands langen Impuls abgibt. Dieser Impuls ist direkt jeweils dem dritten Eingang E3 der ersten und der zweiten Signalweiche S1, S2 zugeführt, an deren jeweiligem ersten Eingang E1 der erste Ausgang A1 bzw. der zweite Ausgang A2 des Phasendiskriminators liegt.

Der Ausgang des zweiten Monoflops M2 liegt ferner über den Inverter I am jeweils zweiten Eingang E2 der ersten bzw. der zweiten Signalweiche S1, S2, an deren jeweils viertem Eingang E4 der Q- bzw. der Q̄-Ausgang des SR-Flipflops RS liegt.

Bei der Erfindung bietet es sich an, die beiden Monoflops M1, M2 mittels digitaler Grundschaltungen zu realisieren. Dies kann beispielsweise mittels eines Zählers geschehen, von dem ein Zählerstand als Ausgang benutzt wird. Im Falle des rücksetzbaren ersten Monoflops M1 weist ein derartiger Zähler auch einen entsprechenden Reset-Eingang auf, so daß die oben geschilderte Funktion erzielt werden kann. Dem Zähler ist ein zu zählendes Taktsignal zugeführt.

Eine bevorzugte Innenschaltung der ersten bzw. der zweiten Signalweiche ist rechts unten in der Figur gezeigt. Sie besteht aus zwei UND-Gliedern, denen die Eingänge E1, E2 bzw. E3, E4 zugeordnet sind, wobei die beiden Ausgänge mittels eines NOR-Gatters verknüpft sind. Bei positiver Logik ist dies die einfachste Realisierungsmöglichkeit für die Signalweichen S1, S2. Soll die Erfindung jedoch mittels negativer Logik realisiert werden, so liegt es im Rahmen fachmännischen Handelns, andere einfache logische Grundglieder zur Realisierung der entsprechenden Funktion zu benutzen.

Aufgrund der Invertierung des Ausgangssignals des zweiten Monoflops M2 mittels des Inverters I sind das zweite und das dritte UND-Gatter U2, U3 im Normalbetrieb der Phasen/Frequenzregelschaltung für die Ausgangssignale des Phasendiskriminators P durchlässig, so daß das SR-Flipflop RS immer entsprechend den Impulsen sich in einem der beiden Zustände befindet. Wenn jedoch der Oszillator VO zu schwingen aufhört, treten an demjenigen der beiden Ausgänge A1, A2 Impulse auf, die die Schaltung weiter in diesem Zustand festhalten, wenn nicht die Maßnahmen zur Lösung des der Erfindung zugrundeliegenden Problems ergriffen werden. In diesem Betriebszustand liegt an den mit dem Inverterausgang verbundenen Eingängen des zweiten und des dritten UND-Gatters U2, U3 ein L-Pegel, so daß der vorausgegangene Zustand der Schaltung mittels des SR-Flipflops RS festgehalten wird, da an seine Eingänge S, R keine Impulse mehr aus dem Phasendiskriminator P gelangen können.

Die beiden Signalweichen S1, S2 haben nun eine derartige Funktion, daß sie das Ausgangssignal des zweiten Monoflops M2, also einen Impuls entsprechender Dauer in direkter oder invertierter Form so auf die beiden Konstantstromquellen Q1, Q2 einwirken lassen, daß die auf den Regeleingang Ev des Oszillators VO einwirkende Regelspannung ihn aus dem unerwünschten Betriebszustand herausbringt. Wenn also beispielsweise die Kapazitätsdiode des Oszillators VO nahe bei ihrer Sperrdurchbruchspannung betrieben wurde, bewirkt der Ausgangsimpuls des zweiten Monoflops M2, daß diese im allgemeinen bei etwa 30 V liegende Spannung vermindert wird.

Als einfachste Realisierungsmöglichkeit ist, wie bereits erwähnt wurde, in der Figur das aus zwei UND-Gliedern und einem NOR-Gatter bestehende Komplexgatter gezeigt. Zum einen werden der Q-Ausgang des SR-Flipflops RS und der Ausgang des zweiten Monoflops M2 UND-verknüpft und zum anderen der erste Ausgang A1 des Phasendiskriminators P und der Ausgang des Inverters I. Sind beide UND-Bedingungen nicht erfüllt, so tritt am Ausgang der ersten Signalweiche S1 ein H-Pegel auf, der die erste Konstantstromquelle Q1, die das Glättungsglied G auflädt, entsprechend steuert.

In vergleichbarer Weise sind mittels der zweiten Signalweiche S2 der Q̄-Ausgang des SR-Flipflops RS und der Ausgang des zweiten Monoflops M2 UND-verknüpft sowie der zweite Ausgang A2 des Phasendiskriminators P und der Ausgang des Inverters I. Am ausgang der zweiten Signalweiche S2 entsteht ein H-Pegel, wenn keine der beiden UND-Bedingungen erfüllt ist.

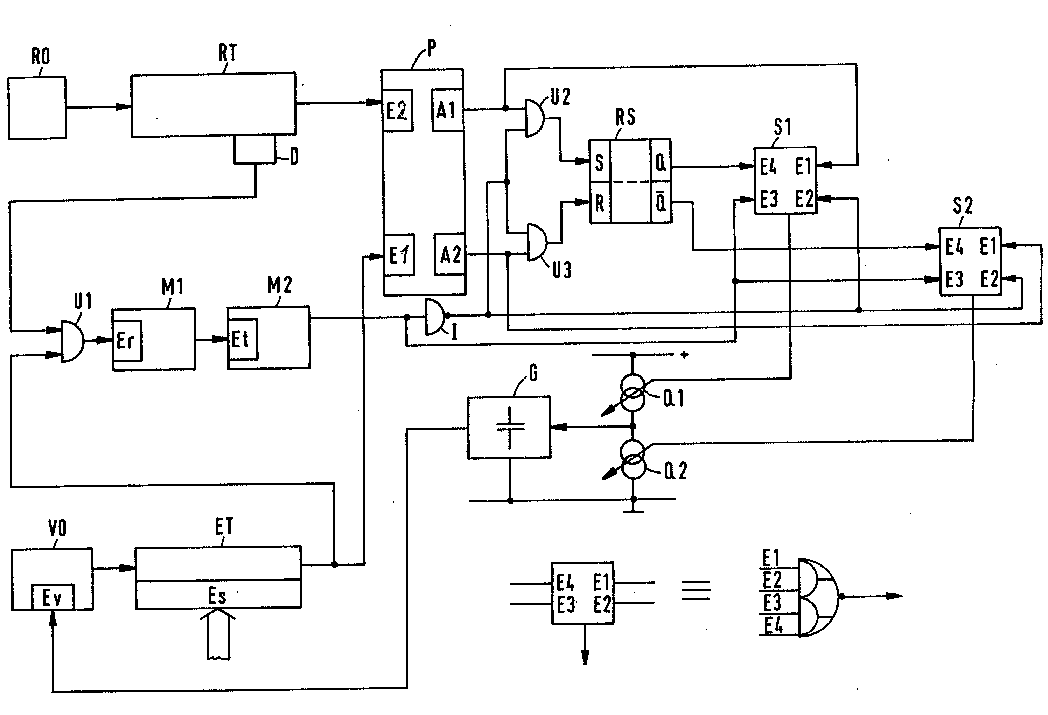

Die digitale Phasen/Frequenzregelschaltung der Erfindung ist somit in der Lage, auch bei einem Aussetzen der Schwingungen des Oszillators VO sich selbst aus diesem unerwünschten Betriebszustand herauszusteuern. Der Hauptvorteil der Erfindung ist somit bereits durch die Lösung der Aufgabe gegeben. Ein weiterer Vorteil besteht darin, daß da die Schaltung ausschließlich aus digital arbeitenden Teilschaltungen besteht, sie vollständig in der Technik integrierter Isolierschicht-Feldeffekttransistor-Schaltungen, also in der sogenannten MOS-Technik, realisiert werden kann. Wie bei der bekannten Anordnung nach der eingangs genannten Offenlegungsschrift handelt es sich beim Phasendiskriminator P vorzugsweise um einen digitalen nach der dortigen Figur 8.

Es stellt keine Abweichung von der Erfindung dar, wenn die einzelnen Funktionen teilweise, insbesondere die der beiden Monoflops M1, M2, oder ganz mittels eines Mikroprozessors oder Mikrocomputers realisiert werden.


**Patentansprüche**

1. Digitale Phasen/Frequenzregelschaltung, bei der das Signal eines von einem Phasendiskriminator (P) bezüglich der Frequenz spannungsgesteuerten Oszillators (VO) mit einer Kapazitätsdiode über einen seiner Frequenzwahl dienenden einstellbaren Frequenzteiler (ET) am ersten Eingang (E1) des Phasendiskriminators (P) und das Signal eines Referenzoszillators (RO) über einen Referenzfrequenzteiler (RT) dem zweiten Eingang (E2) des Phasendiskriminators (P) zugeführt sind und bei der der Phasendiskriminator einen ersten Ausgang (A1) für Impulse zur Frequenzanhebung und einen zweiten Ausgang (A2) für Impulse zur Frequenzabsenkung des Oszillators (VO) aufweist, gekennzeichnet durch folgende Merkmale :

— ein Bereich aufeinanderfolgender Zustände des Referenzfrequenzteilers (RT) ist mittels eines Decoders (D) zur Bildung eines Zeitfensters überwacht,

— der Ausgang des Decoders liegt am ersten Eingang eines ersten UND-Gatters (U1), dessen zweiter Eingang mit dem Ausgang des einstellbaren Frequenzteilers (ET) verbunden ist,

— der Reset-Eingang (Er) eines rücksetzbaren ersten digitalen Monoflops (M1) liegt am Ausgang des ersten UND-Gatters (U1),

— der Trigger-Eingang (Et) eines zweiten digitalen Monoflops (M2) liegt am Ausgang des ersten Monoflops (M1),

— der S-Eingang eines SR-Flipflops (RS) liegt am Ausgang eines zweiten UND-Gatters (U2) und dessen R-Eingang am Ausgang eines dritten UND-Gatters (U3), deren jeweils erster Eingang mit dem über einen Inverter (I) geführten Ausgangssignal des ersten UND-Gatters (U1) gespeist ist,

— der zweite Eingang des zweiten UND-Gatters (U2) bzw. der des dritten UND-Gatters (U3) liegt am ersten bzw. zweiten Ausgang (A1, A2) des Phasendiskriminators (P),

— der erste bzw. der zweite Ausgang des Phasendiskriminators liegen jeweils am ersten Eingang (E1) einer ersten bzw. zweiten Signalweiche (S1, S2), deren zweiten und dritten Eingängen (E2, E3) das über den Inverter (I) geführte bzw. das direkte Ausgangssignal des zweiten Monoflops (M2) zugeführt ist und deren jeweils vierter Eingang (E4) am Q- bzw. Q̄-Ausgang des SR-Flipflops (RS) liegen,

— der Ausgang der ersten Signalweiche (S1) liegt am Steuereingang einer ersten Konstantstromquelle (Q1), deren Strom ein Glättungsglied (G) auflädt, und der Ausgang der zweiten Signalweiche (S2) am Steuereingang einer zweiten Konstantstromquelle (Q2), der das Glättungsglied entlädt, und

— der Ausgang des Glättungsglieds liegt am Steuereingang (Ev) des spannungsgesteuerten Oszillators (VO).

2. Frequenz/Phasenregelschaltung nach Anspruch 1, dadurch gekennzeichnet, da die jeweilige Signalweiche (S1, S2) aus einem deren ersten und zweiten Eingang (E1, E2) verknüpfenden und einem deren dritten und vierten Eingang (E3, E4) verknüpfenden UND-Glied sowie einem deren Ausgänge verknüpfenden NOR-Gatter besteht.

3. Phasen/Frequenzregelschaltung nach Anspruch 1 oder 2, gekennzeichnet durch die Realisierung in der Technik integrierter Isolierschicht-Feldeffekttransistor-Schaltungen.


**Claims**

1. A digital phase/frequency control circuit wherein the signal of a voltage-controlled oscillator (VO) which includes a varactor diode and whose frequency can be varied by a phase discriminator (P) is applied to the second input (E2) of the phase discriminator (P) through a presettable frequency divider (ET) serving to select the frequency of the oscillator, wherein the signal of a reference oscillator (RO) is applied to the first input (E1) of the phase discriminator (P) through a reference-frequency divider (RT), and wherein the phase discriminator has a first output (A1) for pulses raising the frequency of the oscillator and a second output (A2) for pulses lowering the frequency of the oscillator (VO), characterized by the following features :

— a range of successive counts of the reference-frequency divider (RT) is monitored by means of a decoder (D) for forming a time window ;

— the output of the decoder is coupled to the first input of a first AND gate (U1) having its second input connected to the output of a presettable frequency divider (ET) ;

— the reset input (Er) of a resettable first digital monostable multivibrator (M1) is connected to the output of the first AND gate (U1) ;

— the trigger input (Et) of a second digital monostable multivibrator (M2) is connected to the output of the first monostable multivibrator (M1) ;

— the S and R inputs of an RS flip-flop (RS) are connected to the outputs of a second AND gate (U2) and a third AND gate (U3), respectively, to whose first inputs the output signal of the first AND gate (U1) is applied through an inverter (I) ;
— the second inputs of the second AND gate (U2) and the third AND gate (U3) are connected to the first output (A1) and the second output (A2), respectively, of the phase discriminator (P) ;
— the first and second outputs of the phase discriminator are coupled to the first inputs (E1) of a first separation circuit (S1) and a second separation circuit (S2), respectively, to whose second inputs (E2) the output signal of the second monostable multivibrator (M2) is applied through the inverter (I), and whose third inputs (E3) are fed with the output signal of the second monostable multivibrator (M2) direct, while their fourth inputs (E4) are connected to the Q output and the Q̄ output, respectively, of the RS flip-flop (RS) ;
— the output of the first separation circuit (S1) is coupled to the control input of a first constant-current source (Q1) whose current charges a smoothing device (G), and the output of the second separation circuit (S2) is coupled to the control input of a second constant-current source (Q2) which discharges the smoothing device, and
— the output of the smoothing device is coupled to the control input (Ev) of the voltage-controlled oscillator (VO).

2. A frequency/phase control circuit as claimed in claim 1, characterized in that each of the separation circuits (S1, S2) consists of an AND element combining the first input (E1) and the second input (E2) of the separation circuit, an AND element combining the third input (E3) and the fourth input (E4) of the separation circuit, and a NOR element combining the outputs of the two AND elements.

3. A phase/frequency control circuit as claimed in claim 1 or 2, characterized by implementation using insulated-gate field-effect transistor technology.

**Revendications**

1. Circuit numérique de réglage de phase-fréquence dans lequel le signal d'un oscillateur (VO), commandé en tension par un discriminateur de phase, en ce qui concerne la fréquence, et pourvu d'une diode à capacité variable, est transmis à la première entrée (E1) d'un discriminateur de phase (P) par l'intermédiaire d'un diviseur de fréquence réglable (ET) servant à choisir la fréquence, dans lequel le signal d'un oscillateur de référence (RO) est transmis à la seconde entrée (E2) du discriminateur de phase (P) par l'intermédiaire d'un diviseur de fréquence de référence (RT), et dans lequel le discriminateur de phase possède une première sortie (A1) réservée aux impulsions d'élévation de fréquence et une seconde sortie (A2) réservée aux impulsions d'abaissement de fréquence de l'oscillateur (VO), caractérisé en ce que :
— une plage d'états successifs du diviseur de fréquence de référence (RT) est surveillée par un décodeur (D) pour former une fenêtre de temps,
— la sortie du décodeur est reliée à la première entrée d'une première porte ET (U1) dont la seconde entrée est raccordée à la sortie du diviseur de fréquence réglable (ET),
— l'entrée de remise à l'état initial (Er) d'une première bascule numérique redéclenchable (M1) est reliée à la sortie de la première porte ET (U1),
— l'entrée de déclenchement (Et) d'une seconde bascule numérique monostable (M2) est reliée à la sortie de la première bascule monostable (M1),
— l'entrée S d'une bascule (RS) est reliée à la sortie d'une seconde porte ET (U2) et son entrée R à la sortie d'une troisième porte ET (U3) dont chacun des premières entrées est alimentée par le signal de sortie de la première porte ET (U1) transmis par un inverseur (I),
— la seconde entrée de la seconde porte ET (U2) ou de la troisième porte ET (U3) est reliée à la première ou à la seconde entrée selon le cas (A1, A2) du discriminateur de phase (P),
— la première ou la seconde sortie, selon le cas, du discriminateur de phase sont reliées à la première entrée (E1) du premier ou du second, selon le cas, dispositif d'aiguillage de signaux (S1, S2) vers les deuxième et troisième entrées desquels (E2, E3) est dirigé le signal de sortie de la seconde bascule monostable (M2) transmis directement ou par l'intermédiaire de l'inverseur (I) et dont les quatrièmes entrées (E4) sont reliées, selon le cas, aux sorties Q ou Q̄ de la bascule (RS),
— la sortie du premier dispositif d'aiguillage de signaux (S1) est reliée à l'entrée de commande d'une première source de courant constant (Q1) dont le courant alimente un élément de lissage (G), et la sortie du second dispositif d'aiguillage de signaux (S2) est reliée à l'entrée de commande d'une seconde source de courant constant (Q2) alimentant l'élément de lissage, et
— la sortie de l'élément de lissage est reliée à l'entrée de commande (Ev) de l'oscillateur commandé en tension (VO).

2. Circuit de réglage de phase-fréquence conforme à la revendication 1, caractérisé en ce que les dispositifs d'aiguillage de signaux (S1, S2) se composent d'un élément ET associé à leur première et leur seconde entrée (E1, E2) et leur troisième et leur quatrième entrée (E3, E4) ainsi que d'une porte NOR associée à leur sortie.

3. Circuit de réglage de phase-fréquence conforme aux revendications 1 ou 2, caractérisé en ce qu'il est réalisé selon la technique des transistors à effet de champ à grille isolée.